# EUROPEAN PATENT APPLICATION

(11) **EP 4 712 725 A1**
(43) Date of publication of application: **18.03.2026**
(21) Application number: 25173193.1
(22) Date of filing: 29.04.2025
(51) Int. Cl.: H10D 30/67

(54) **THIN FILM TRANSISTORS HAVING RECESSED CONTACT METALLIZATION**

(30) Priority: 28.06.2024 US 202418757951
(71) Applicant: INTEL Corporation, Santa Clara, CA 95054 (US)
(72) Inventor: DOLEJSI, Moshe, Portland, 97229 (US); VENKATRAMAN, Vishak, Hillsboro, 97124 (US); TANEJA, Deepyanti, Happy Valley, 97086 (US); LE, Van H., Beaverton, 97007 (US); LAJOIE, Travis W., Forest Grove, 97116 (US); MATHEW, Suraj, Albuquerque, 87122 (US); SHARMA, Abhishek Anil, Portland, 97229 (US); WIEGAND, Christopher J., 97229, Portland (US); GEORGE, Gregory J., Beaverton, 97007 (US); KEKUNAWELA PATHIRANAGE, Taniya, Hillsboro, 97124 (US); ALCANTARA, Juichin, Beaverton, 97078 (US); WADEKAR, Shardul, Hillsboro, 97123 (US); HEIL, Philip E., Hillsboro, 97124 (US); HUANG, Yu-Wen, Beaverton, 97078 (US); MEHTA, Nikhil, Portland, 97229 (US); STETTLER, Joel M., Portland, 97202 (US)
(74) Representative: Goddar, Heinz J.

(57) **Abstract**

Thin film transistors are described. An integrated circuit structure includes a gate electrode. A gate dielectric layer is on the gate electrode. A channel material layer is on the gate dielectric layer. A dielectric layer is over the channel material layer. Source or drain contacts are on the channel material layer. Each of the source or drain contacts includes a semiconductor material layer, a conductive liner within the semiconductor material layer, and a conductive fill within the conductive liner. One, two or all three of the semiconductor material layer, the conductive liner, or the conductive fill has an uppermost surface below an uppermost surface of the dielectric layer.

## Description

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips.

For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant. In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and compatibility with the existing high-yielding bulk silicon substrate infrastructure. Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

The performance of a thin-film transistor (TFT) may depend on a number of factors. For example, the efficiency at which a TFT is able to operate may depend on the sub threshold swing of the TFT, characterizing the amount of change in the gate-source voltage needed to achieve a given change in the drain current. A smaller sub threshold swing enables the TFT to turn off to a lower leakage value when the gate-source voltage drops below the threshold voltage of the TFT. The conventional theoretical lower limit at room temperature for the sub threshold swing of the TFT is 60 millivolts per decade of change in the drain current.

Variability in conventional and state-of-the-art fabrication processes may limit the possibility to further extend them into the, e.g. 10 nm or sub-10 nm range. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1 illustrates a cross-sectional view of a thin film transistor having a non-recessed contact metallization.
Figure 2 illustrates cross-sectional views of various thin film transistors having recessed contact metallization, in accordance with an embodiment of the present disclosure.
Figure 3 illustrates cross-sectional views of various thin film transistors having recessed contact metallization, in accordance with an embodiment of the present disclosure.
Figures 4A and 4B illustrate cross-sectional views representing various operations in a method of fabricating a thin film transistor having recessed contact metallization, in accordance with an embodiment of the present disclosure.
Figure 5 illustrates a cross-sectional view of a planar thin film integrated circuit structure, in accordance with an embodiment of the present disclosure.
Figure 6 illustrates a cross-sectional view of a non-planar thin film integrated circuit structure, in accordance with an embodiment of the present disclosure.
Figures 7A and 7B are top views of a wafer and dies that include one or more thin film transistors having recessed contact metallization, in accordance with one or more of the embodiments disclosed herein.
Figure 8 is a cross-sectional side view of an integrated circuit (IC) device that may include one or more thin film transistors having recessed contact metallization, in accordance with one or more of the embodiments disclosed herein.
Figure 9 is a cross-sectional side view of an integrated circuit (IC) device assembly that may include one or more thin film transistors having recessed contact metallization, in accordance with one or more of the embodiments disclosed herein.
Figure 10 illustrates a computing device in accordance with one implementation of an embodiment of the disclosure.

### DESCRIPTION OF THE EMBODIMENTS

Thin film transistors (TFTs) having recessed contact metallization are described. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments described herein are directed to structures and architectures for fabricating BEOL thin film transistors (TFTs) having recessed contact metallization. Embodiments may include or pertain to one or more of back end transistors, semiconducting oxide materials, thin film transistors, and system-on-chip (SoC) technologies. One or more embodiments may be implemented as a transistor for and eDRAM structure, such as a one transistor-one capacitor 1T-1C TFT-based eDRAM structure. One or more embodiments may be implemented to realize high performance backend transistors to potentially increase monolithic integration of backend logic plus memory in SoCs of future technology nodes.

To provide context, there is increased need for advanced SoCs to include monolithically integrated BEOL transistors for logic functionality at higher metal layers. Such BEOL transistors typically have a lower thermal budget than front end transistors due to increased thermal sensitivity of backend materials. Also, the performance of such transistors may be severely hampered due to low channel mobility for BEOL-compatible channel materials.

To provide further context, a multi-layered contact for a TFT may have an exposed layer that is not compatible with standard BEOL processing or materials. In an embodiment, one or more layers of a multi-layered contact for a TFT is recessed to enhance compatibility of such contacts with BEOL materials and processes.

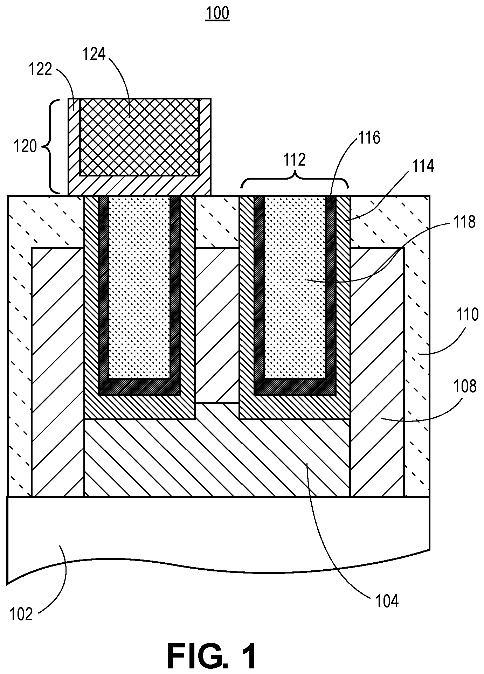

As a comparative example, Figure 1 illustrates a cross-sectional view of a thin film transistor having a non-recessed contact metallization.

Referring to Figure 1, an integrated circuit structure 100 includes a lower substrate or device layer or metallization layer 102. Although not depicted, a layer including a bottom gate electrode and gate dielectric layer can be included in or on the lower substrate or device layer or metallization layer 102. A channel material layer 104 is above the lower substrate or device layer or metallization layer 102, such as on a gate dielectric layer which is on a gate electrode. Dielectric layers, such as first dielectric layer 108 and second dielectric layer 110, can be included over the channel material layer 104 and the lower substrate or device layer or metallization layer 102. Source or drain contacts 112 extend through the dielectric layers 108/110 and are on the channel material layer 104, and can be partially recessed into the channel material layer 104 as is depicted. The source or drain contacts 112 each include a semiconductor material layer 114, a conductive liner 116 within the semiconductor material layer 114, and a conductive fill 118 within the conductive liner 116. The source or drain contacts 112 are non-recessed conductive contacts since all three layers 114, 116 and 118 have uppermost surfaces at a same level as an uppermost surface of the dielectric layers 108/110. As a result, an overlying BEOL conductive via 120 (which can include a conductive liner 122 and a conductive fill 124) is in contact with all three layers 114, 116 and 118 of the source or drain contacts 112.

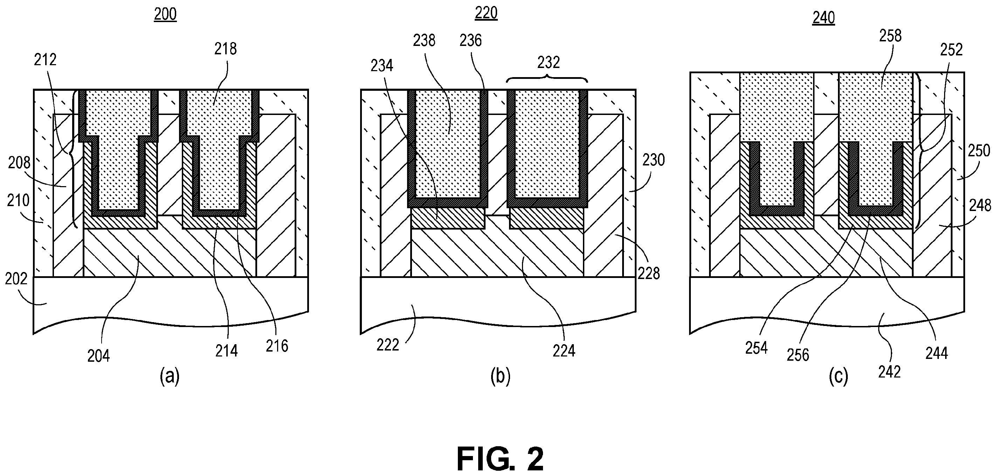

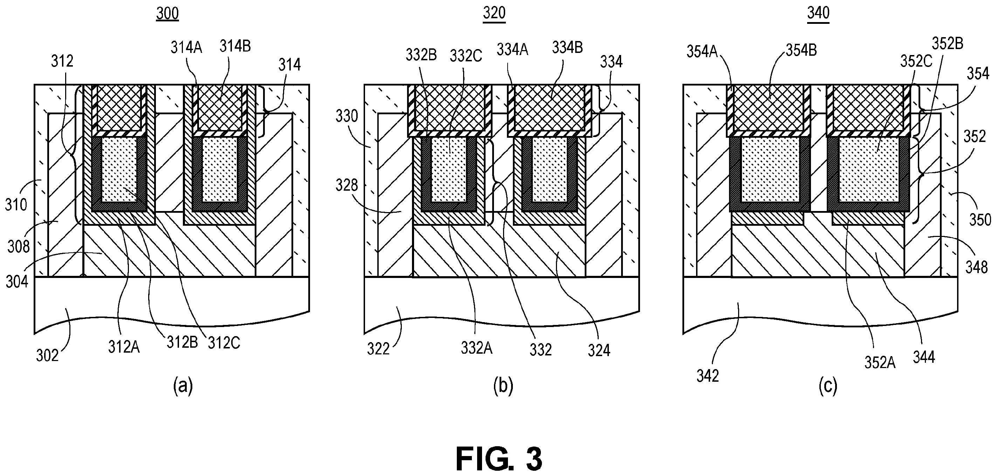

By contrast to Figure 1, Figure 2 illustrates cross-sectional views of various thin film transistors having recessed contact metallization, in accordance with an embodiment of the present disclosure. Figure 3 illustrates cross-sectional views of various thin film transistors having recessed contact metallization, in accordance with an embodiment of the present disclosure.

Referring to part (a) of Figure 2, an integrated circuit structure 200 includes a lower substrate or device layer or metallization layer 202. Although not depicted, a layer including a bottom gate electrode and gate dielectric layer can be included in or on the lower substrate or device layer or metallization layer 202. A channel material layer 204 is above the lower substrate or device layer or metallization layer 202, such as on a gate dielectric layer which is on a gate electrode. Dielectric layers, such as first dielectric layer 208 and second dielectric layer 210, can be included over the channel material layer 204 and the lower substrate or device layer or metallization layer 202. Source or drain contacts 212 extend through the dielectric layers 208/210 and are on the channel material layer 204, and can be partially recessed into the channel material layer 204 as is depicted. The source or drain contacts 212 each include a semiconductor material layer 214, a conductive liner 216 within the semiconductor material layer 214, and a conductive fill 218 within the conductive liner 216. The source or drain contacts 212 are recessed conductive contacts since semiconductor material layer 214 has an uppermost surface below an uppermost surface of the dielectric layers 208/210. As a result, an overlying BEOL conductive via (not shown) would be in contact with layers 216 and 218, but not with layer 214, of the source or drain contacts 212.

Referring to part (b) of Figure 2, an integrated circuit structure 220 includes a lower substrate or device layer or metallization layer 222. Although not depicted, a layer including a bottom gate electrode and gate dielectric layer can be included in or on the lower substrate or device layer or metallization layer 222. A channel material layer 224 is above the lower substrate or device layer or metallization layer 222, such as on a gate dielectric layer which is on a gate electrode. Dielectric layers, such as first dielectric layer 228 and second dielectric layer 230, can be included over the channel material layer 224 and the lower substrate or device layer or metallization layer 222. Source or drain contacts 232 extend through the dielectric layers 228/230 and are on the channel material layer 224, and can be partially recessed into the channel material layer 224 as is depicted. The source or drain contacts 232 each include a semiconductor material layer 234, a conductive liner 236 within the semiconductor material layer 234, and a conductive fill 238 within the conductive liner 236. The source or drain contacts 232 are recessed conductive contacts since semiconductor material layer 234 has an uppermost surface below an uppermost surface of the dielectric layers 228/230. As a result, an overlying BEOL conductive via (not shown) would be in contact with layers 236 and 238, but not with layer 234, of the source or drain contacts 232.

Referring to part (c) of Figure 2, an integrated circuit structure 240 includes a lower substrate or device layer or metallization layer 242. Although not depicted, a layer including a bottom gate electrode and gate dielectric layer can be included in or on the lower substrate or device layer or metallization layer 242. A channel material layer 244 is above the lower substrate or device layer or metallization layer 242, such as on a gate dielectric layer which is on a gate electrode. Dielectric layers, such as first dielectric layer 248 and second dielectric layer 250, can be included over the channel material layer 244 and the lower substrate or device layer or metallization layer 242. Source or drain contacts 252 extend through the dielectric layers 248/250 and are on the channel material layer 244, and can be partially recessed into the channel material layer 244 as is depicted. The source or drain contacts 252 each include a semiconductor material layer 254, a conductive liner 256 within the semiconductor material layer 254, and a conductive fill 258 within the conductive liner 256. The source or drain contacts 252 are recessed conductive contacts since semiconductor material layer 254 and conductive liner 256 have an uppermost surface below an uppermost surface of the dielectric layers 248/250. As a result, an overlying BEOL conductive via (not shown) would be in contact with layer 258, but not with layers 254 and 256, of the source or drain contacts 252. It is to be appreciated that layer 256 may be recessed to same level as layer 254 (as depicted) or can be recessed to a slightly higher point such that layer 254 and layer 258 do not interact, but that only layer 258 is at the top.

Referring to part (a) of Figure 3, an integrated circuit structure 300 includes a lower substrate or device layer or metallization layer 302. Although not depicted, a layer including a bottom gate electrode and gate dielectric layer can be included in or on the lower substrate or device layer or metallization layer 302. A channel material layer 304 is above the lower substrate or device layer or metallization layer 302, such as on a gate dielectric layer which is on a gate electrode. Dielectric layers, such as first dielectric layer 308 and second dielectric layer 310, can be included over the channel material layer 304 and the lower substrate or device layer or metallization layer 302. Source or drain contacts 312 extend through the dielectric layers 308/310 and are on the channel material layer 304, and can be partially recessed into the channel material layer 304 as is depicted. The source or drain contacts 312 each include a semiconductor material layer 312A, a conductive liner 312B within the semiconductor material layer 312A, and a conductive fill 312C within the conductive liner 312B. The source or drain contacts 312 are recessed conductive contacts since conductive liner 312B and conductive fill 312C have an uppermost surface below an uppermost surface of the dielectric layers 308/310. The integrated circuit structure 300 further includes an internal conductive structure 314, which can include a conductive liner 314A and a conductive fill 314B, within the corresponding recesses of the source or drain contacts 312. As a result, an overlying BEOL conductive via (not shown) would be in contact with layer 312A of the source or drain contacts 312 and with the conductive structure 314, but not with layers 312B and 312C of the source or drain contacts 312.

Referring to part (b) of Figure 3, an integrated circuit structure 320 includes a lower substrate or device layer or metallization layer 322. Although not depicted, a layer including a bottom gate electrode and gate dielectric layer can be included in or on the lower substrate or device layer or metallization layer 322. A channel material layer 324 is above the lower substrate or device layer or metallization layer 322, such as on a gate dielectric layer which is on a gate electrode. Dielectric layers, such as first dielectric layer 328 and second dielectric layer 330, can be included over the channel material layer 324 and the lower substrate or device layer or metallization layer 322. Source or drain contacts 332 extend through the dielectric layers 328/330 and are on the channel material layer 324, and can be partially recessed into the channel material layer 324 as is depicted. The source or drain contacts 332 each include a semiconductor material layer 332A, a conductive liner 332B within the semiconductor material layer 332A, and a conductive fill 332C within the conductive liner 332B. The source or drain contacts 332 are recessed conductive contacts since semiconductor material layer 332A, conductive liner 332B and conductive fill 332C have an uppermost surface below an uppermost surface of the dielectric layers 328/330. The integrated circuit structure 320 further includes an internal conductive structure 334, which can include a conductive liner 334A and a conductive fill 334B, within the corresponding recesses of the source or drain contacts 332. As a result, an overlying BEOL conductive via (not shown) would be in contact with the conductive structure 334, but not with layers 332A, 332B and 332C of the source or drain contacts 332.

Referring to part (c) of Figure 3, an integrated circuit structure 340 includes a lower substrate or device layer or metallization layer 342. Although not depicted, a layer including a bottom gate electrode and gate dielectric layer can be included in or on the lower substrate or device layer or metallization layer 342. A channel material layer 344 is above the lower substrate or device layer or metallization layer 342, such as on a gate dielectric layer which is on a gate electrode. Dielectric layers, such as first dielectric layer 348 and second dielectric layer 350, can be included over the channel material layer 344 and the lower substrate or device layer or metallization layer 342. Source or drain contacts 352 extend through the dielectric layers 348/350 and are on the channel material layer 344, and can be partially recessed into the channel material layer 344 as is depicted. The source or drain contacts 352 each include a semiconductor material layer 352A, a conductive liner 352B within the semiconductor material layer 352A, and a conductive fill 352C within the conductive liner 352B. The source or drain contacts 352 are recessed conductive contacts since semiconductor material layer 352A, conductive liner 352B and conductive fill 352C have an uppermost surface below an uppermost surface of the dielectric layers 348/350. The integrated circuit structure 340 further includes an internal conductive structure 354, which can include a conductive liner 354A and a conductive fill 354B, within the corresponding recesses of the source or drain contacts 352. As a result, an overlying BEOL conductive via (not shown) would be in contact with the conductive structure 354, but not with layers 352A, 352B and 352C of the source or drain contacts 352.

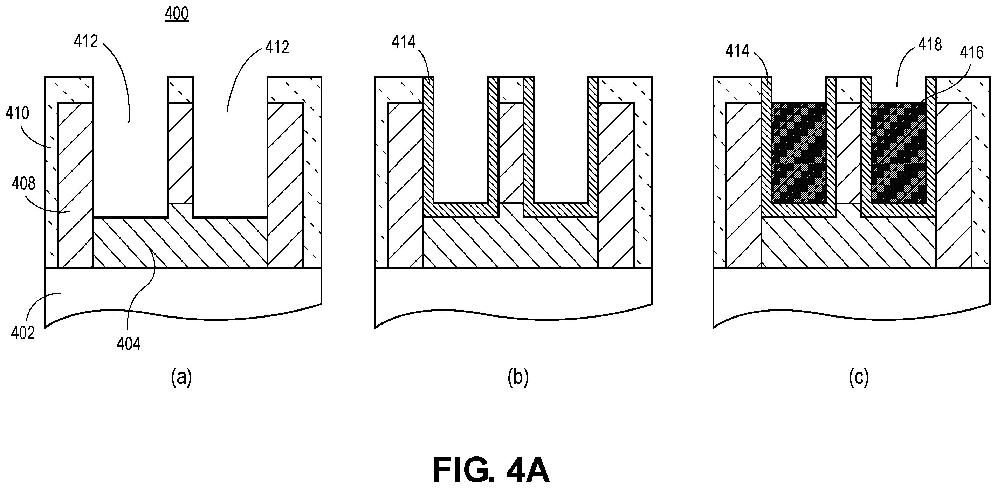

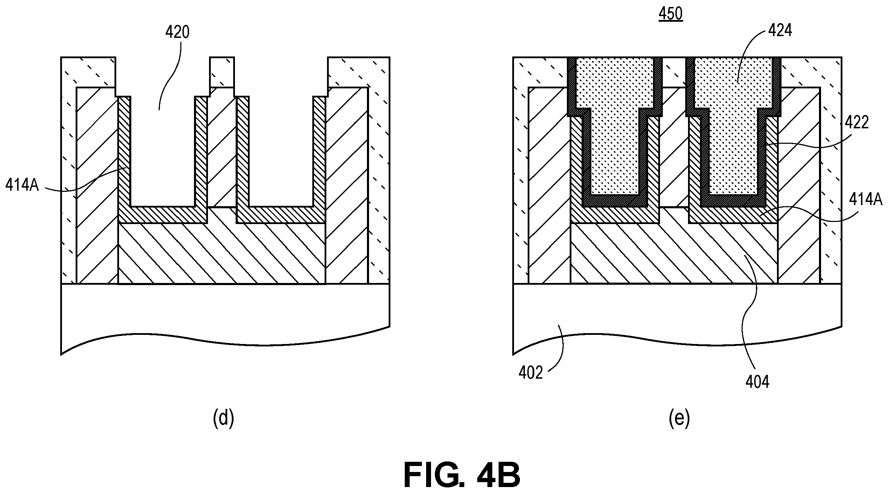

As an exemplary process flow, Figures 4A and 4B illustrate cross-sectional views representing various operations in a method of fabricating a thin film transistor having recessed contact metallization, in accordance with an embodiment of the present disclosure.

Referring to part (a) of Figure 4A, a starting structure 400 includes a lower substrate or device layer or metallization layer 402. Although not depicted, a layer including a bottom gate electrode and gate dielectric layer can be included in or on the lower substrate or device layer or metallization layer 402. A channel material layer 404 is above the lower substrate or device layer or metallization layer 402, such as on a gate dielectric layer which is on a gate electrode. Dielectric layers, such as first dielectric layer 408 and second dielectric layer 410, can be included over the channel material layer 404 and the lower substrate or device layer or metallization layer 402. Source or drain contact openings 412 are formed to extend through the dielectric layers 408/410 and land on the channel material layer 404, and can be partially recessed into the channel material layer 404 as is depicted.

Referring to part (b) of Figure 4A, a semiconductor material layer 414 is formed along sides and a bottom of each of the source or drain contact openings 412.

Referring to part (c) of Figure 4A, a sacrificial hardmask material 416 is formed within the semiconductor material layer 414 and is recessed to have recesses 418 there over.

Referring to part (d) of Figure 4B, the exposed portions of the semiconductor material layer 414, e.g., the portions in recesses 418, are etched to form recessed semiconductor material layer 414A. The dielectric layers may be slightly laterally recessed during the process, as is depicted. The sacrificial hardmask material 416 is then removed.

Referring to part (e) of Figure 4B, a conductive liner 422 is formed within and over the recessed semiconductor material layer 414A. A conductive fill 424 is then formed within the conductive liner 422. The recessed semiconductor material layer 414A, the conductive liner 422, and the conductive fill 424 together form source or drain contacts for an integrated circuit structure 450.

In another aspect, in accordance with one or more embodiments described herein, non-planar BEOL-compatible thin film transistors (TFTs) are fabricated by effectively increasing the transistor channel length for a given projected area. A TFT fabricated using such an architecture may exhibit an increase in gate control, stability, and performance of thin film transistors. Applications of such systems may include, but are not limited to, back-end-of-line (BEOL) logic, memory, or analog applications. Embodiments described herein may include non-planar structures that effectively increase transistor length (relative to a planar device) by integrating the devices in unique architectures.

In an embodiment, very long channel thin film transistors are implemented into an integrated circuit with high area/footprint efficiency. Such long-channel structures may be useful for low-leakage/low power applications. In particular embodiments, a three-dimensional thin film semiconductor is gated from a gate stack pedestal to provide a channel length which is varied depending on the height of the gate stack pedestal. In one embodiment, very long channel TFT devices are described that do not have an area penalty that would typically be associated with other TFT devices. TFT devices described herein may be integrated anywhere within a semiconductor die (e.g., above an existing layer of devices, adjacent to existing devices, etc.). For ease of illustration, some devices are described herein in an isolated environment without other features present. Such other features would be apparent to one skilled in the art.

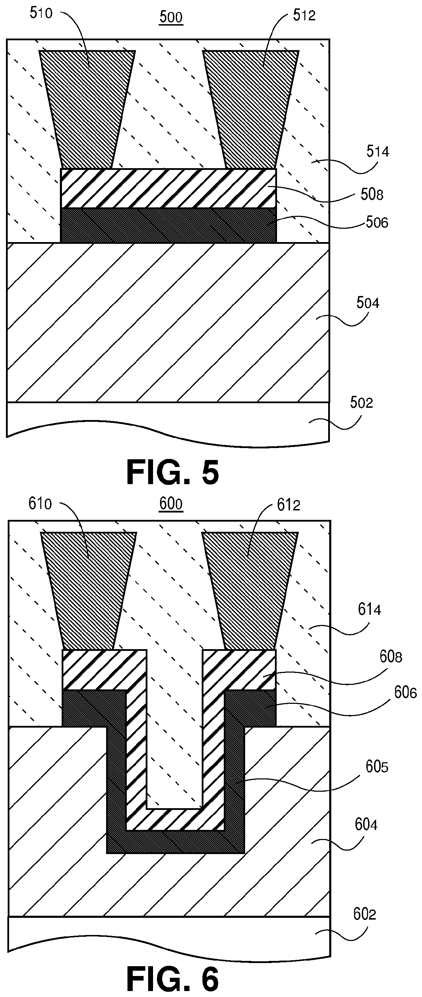

In another aspect, to provide context, most state of the art thin film transistors are single gate. This has a consequence that as area scales, gate length scales and it becomes more difficult to turn off the transistor channel. In an embodiment, using a vertical gate device increases the gate length in the same footprint allowing a cell area to continue to scale, but with a dimension where a gate length can remain long and thus result in better channel control. In an exemplary embodiment, a feature is etched into a bottom metal line on which a back end thin film transistor is formed and gated. The trench increases the gate length of the device in the same top down area to enable better gate control without resorting to aggressive gate oxide thinning or resorting to double and triple gates or gate-all-around devices. To provide an illustrative comparison for the above concepts concerning vertical TFTs in general, Figure 5 illustrates a cross-sectional view of a planar thin film integrated circuit structure, in accordance with an embodiment of the present disclosure. Figure 6 illustrates a cross-sectional view of a non-planar thin film integrated circuit structure, in accordance with an embodiment of the present disclosure.

Referring to Figure 5, an integrated circuit structure 500 includes a gate electrode 504 above a structure 502, such as a structure including a lower via coupled to the gate electrode 504. A channel material layer 508 is over the gate electrode 504. A first source or drain contact 510 is coupled to the channel material layer 508 at a first end of the channel material layer 508. A second source or drain contact 512 is coupled to the channel material layer 508 at a second end of the channel material layer 508. A dielectric layer 514 is on the channel material layer 508. A gate dielectric layer 506 is between the gate electrode 504 and the channel material layer 508. In an embodiment, although not depicted as such, one or both of the first source or drain contact 510 or the second source or drain contact 512 is a recessed source or drain contact, such as those described above.

Referring to Figure 6, an integrated circuit structure 600 includes a gate electrode 604 above a structure 602, such as a structure including a lower via coupled to the gate electrode 604. The gate electrode 604 has a trench therein. A channel material layer 608 is over the gate electrode 604 and in the trench. The channel material layer 608 is conformal with the trench. A first source or drain contact 610 is coupled to the channel material layer 608 at a first end of the channel material layer 608 outside of the trench. A second source or drain contact 612 is coupled to the channel material layer 608 at a second end of the channel material layer 608 outside of the trench. In an embodiment, the integrated circuit structure 600 further includes a dielectric layer 614 on the channel material layer 608 and in the trench, as is depicted in Figure 6. In an embodiment, the integrated circuit structure 600 further includes a gate dielectric layer 606 between the gate electrode 602 and the channel material layer 608. In an embodiment, although not depicted as such, one or both of the first source or drain contact 610 or the second source or drain contact 612 is a recessed source or drain contact, such as those described above.

It is to be appreciated that the layers and materials described in association with embodiments herein are typically formed on or above an underlying semiconductor substrate, e.g., as FEOL layer(s). In other embodiments, the layers and materials described in association with embodiments herein are typically formed on or above underlying device layer(s) of an integrated circuit, e.g., as BEOL layer(s) above an underlying semiconductor substrate. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, although not depicted, structures described herein may be fabricated on underlying lower level back-end-of-line (BEOL) interconnect layers.

In the case that an insulator layer is included between a plurality of thin film transistors and an underlying substrate, the insulator layer may be composed of a material suitable to ultimately electrically isolate, or contribute to the isolation of, thin film transistors from an underlying bulk substrate or interconnect layer. For example, in one embodiment, such an insulator layer is composed of a dielectric material such as, but not limited to, silicon dioxide, silicon oxy-nitride, silicon nitride, or carbon-doped silicon nitride. In a particular embodiment, such an insulator layer is a low-k dielectric layer of an underlying BEOL layer.

In an embodiment, the channel material layer of a TFT includes an IGZO layer that has a gallium to indium ratio of 1:1, a gallium to indium ratio greater than 1 (e.g., 2:1, 3:1, 4:1, 5:1, 6:1, 7:1, 8:1, 9:1, or 10:1), or a gallium to indium ratio less than 1 (e.g., 1:2, 1:3, 1:4, 1:5, 1:6, 1:7, 1:8, 1:9, or 1:10). A low indium content IGZO may refer to IGZO having more gallium than indium (e.g., with a gallium to indium ratio greater than 1:1), and may also be referred to as high gallium content IGZO. Similarly, low gallium content IGZO may refer to IGZO having more indium than gallium (e.g., with a gallium to indium ratio less than 1:1), and may also be referred to as high indium content IGZO. In another embodiment, the channel material layer is or includes a material such as tin oxide, antimony oxide, indium oxide, indium tin oxide, titanium oxide, zinc oxide, indium zinc oxide, gallium oxide, titanium oxynitride, ruthenium oxide, or tungsten oxide. In another embodiment, polycrystalline silicon is used as the channel material instead of a semiconducting oxide material. In an embodiment, no matter the composition, the channel material layer has a thickness between 5 nanometers and 30 nanometers. In another embodiment, the channel material layer of a TFT includes an oxide semiconductor such as, but not limited to, SnO, SnO₂, Cu₂O, CoO, ZnO, Ga₂O₃, IZO, ITO, AZO, or TiO₂. In another embodiment, the channel material layer includes a material such as, but not limited to, poly-Si, poly-SiGe, poly-Ge, poly-III-V, BeTe, or other tellurides. In another embodiment, the channel material layer includes a material such as, but not limited to, MoS₂, MoSe₂, WSe₂, WS₂, black phosphorus, SnO, Cu₂O, CuSnO, NiO, NbO, ITZO, IZO, AZO, AZTO, Ga₂O₃, IGO, ITO, and bi- or multi-layers thereof.

In an embodiment, the channel material layer is an amorphous, crystalline, or semi crystalline oxide semiconductor, such as an amorphous, crystalline, or semi crystalline oxide semiconducting IGZO layer. The semiconducting oxide material may be formed using a low-temperature deposition process, such as physical vapor deposition (PVD) (e.g., sputtering), atomic layer deposition (ALD), or chemical vapor deposition (CVD). The ability to deposit the semiconducting oxide material at temperatures low enough to be compatible with back-end manufacturing processes represents a particular advantage. The semiconducting oxide material may be deposited on sidewalls or conformably on any desired structure to a precise thickness, allowing the manufacture of transistors having any desired geometry.

In an embodiment, gate electrodes described herein include at least one P-type work function metal or N-type work function metal, depending on whether the integrated circuit device is to be included in a P-type transistor or an N-type transistor. For a P-type transistors, metals that may be used for the gate electrode may include, but are not limited to, ruthenium, palladium, platinum, cobalt, nickel, and conductive metal oxides (e.g., ruthenium oxide). For an N-type transistor, metals that may be used for the gate electrode include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode includes a stack of two or more metal layers, where one or more metal layers are work function metal layers and at least one metal layer is a fill metal layer, such as tungsten. Further metal layers may be included for other purposes, such as to act as a barrier layer.

In an embodiment, gate dielectric layers described herein are composed of or include a high-k material. For example, in one embodiment, a gate dielectric layer is composed of a material such as, but not limited to, hafnium oxide, hafnium oxy-nitride, hafnium silicate, lanthanum oxide, zirconium oxide, zirconium silicate, tantalum oxide, barium strontium titanate, barium titanate, strontium titanate, yttrium oxide, aluminum oxide, lead scandium tantalum oxide, lead zinc niobate, or a combination thereof. In an embodiment, gate dielectric layers described herein are composed of or include HfO₂, HZO, ZrO₂, HfSiOx, HfA₁Ox, Al₂O₃, HfO₂, YZO, Y₂O₃, TaSiOx, AlSiOx, or La₂O₃, HfLaOx.

In some embodiments, the channel material is in contact with a gate dielectric layer, an arrangement which may put an IGZO layer in contact with a high-k metal oxide layer. In other embodiments, an intermediate material is disposed between the channel material and the gate dielectric layer. In some embodiments, an IGZO layer includes multiple regions of IGZO having different material properties. For example, an IGZO layer may include low indium content IGZO close to (e.g., in contact with) a high-k gate dielectric layer, and a high indium content IGZO farther from the high-k gate dielectric layer.

In an embodiment, conductive contacts act as contacts to source or drain regions of a TFT, or act directly as source or drain regions of the TFT. The conductive contacts may be spaced apart by a distance that is the gate length of the transistor integrated circuit device. In some embodiments, the gate length is between 7 and 30 nanometers. In an embodiment, the conductive contacts include one or more layers of metal and/or metal alloys. In a particular embodiment, the conductive contacts are composed of copper or a copper-containing alloy, or aluminum or an aluminum-containing alloy.

In accordance with at least some embodiments of the present disclosure, such as those described in association with Figures 2, 3 and 4A-4B, the conductive contacts are recessed conductive contacts including a semiconductor material layer, a conductive liner within the semiconductor material layer, and a conductive fill within the conductive liner. In one embodiment, the semiconductor material layer of a recessed conductive contact includes one or more of poly-Si, poly-SiGe, poly-Ge, or poly-III-V. In one embodiment, the conductive liner of a recessed conductive contact includes a metal nitride material, such as tantalum nitride or titanium nitride. In one embodiment, the conductive fill of a recessed conductive contact is composed of a conductive material such as, but not limited to, Cu, Al, Ti, Zr, Hf, V, Ru, Co, Ni, Pd, Pt, W, Ag, Au or alloys thereof. It is to be appreciated that, in general, the boundaries of the contact materials are depicted as perfectly fitting pure materials. It may be the case that parasitic interfaces, e.g., oxide containing, are present at the borders of any two materials, with a potential for seams/voids.

In an embodiment, interconnect lines (and, possibly, underlying via structures), such as interconnect lines, described herein are composed of one or more metal or metal-containing conductive structures. The conductive interconnect lines are also sometimes referred to in the art as traces, wires, lines, metal, interconnect lines or simply interconnects. In a particular embodiment, each of the interconnect lines includes a barrier layer and a conductive fill material. In an embodiment, the barrier layer is composed of a metal nitride material, such as tantalum nitride or titanium nitride. In an embodiment, the conductive fill material is composed of a conductive material such as, but not limited to, Cu, Al, Ti, Zr, Hf, V, Ru, Co, Ni, Pd, Pt, W, Ag, Au or alloys thereof.

Interconnect lines described herein may be fabricated as a grating structure, where the term "grating" is used herein to refer to a tight pitch grating structure. In one such embodiment, the tight pitch is not achievable directly through conventional lithography. For example, a pattern based on conventional lithography may first be formed, but the pitch may be halved by the use of spacer mask patterning, as is known in the art. Even further, the original pitch may be quartered by a second round of spacer mask patterning. Accordingly, the grating-like patterns described herein may have conductive lines spaced at a constant pitch and having a constant width. The pattern may be fabricated by a pitch halving or pitch quartering, or other pitch division, approach.

In an embodiment, ILD materials described herein are composed of or include a layer of a dielectric or insulating material. Examples of suitable dielectric materials include, but are not limited to, oxides of silicon (e.g., silicon dioxide (SiO₂)), doped oxides of silicon, fluorinated oxides of silicon, carbon doped oxides of silicon, various low-k dielectric materials known in the arts, and combinations thereof. The interlayer dielectric material may be formed by conventional techniques, such as, for example, chemical vapor deposition (CVD), physical vapor deposition (PVD), or by other deposition methods.

In an embodiment, lithographic operations are performed using 193nm immersion lithography (i193), extreme ultra-violet (EUV) and/or electron beam direct write (EBDW) lithography, or the like. A positive tone or a negative tone resist may be used. In one embodiment, a lithographic mask is a tri-layer mask composed of a topographic masking portion, an anti-reflective coating (ARC) layer, and a photoresist layer. In a particular such embodiment, the topographic masking portion is a carbon hardmask (CHM) layer and the anti-reflective coating layer is a silicon ARC layer.

It is to be appreciated that not all aspects of the processes described above need be practiced to fall within the spirit and scope of embodiments of the present disclosure. Also, the processes described herein may be used to fabricate one or a plurality of semiconductor devices. One or more embodiments may be particularly useful for fabricating semiconductor devices at a 10 nanometer (10 nm) or smaller technology node.

In another aspect, the performance of a thin film transistor (TFT) may depend on the carrier mobility of the components in the TFT. For example, a material with a higher carrier mobility enables carriers to move more quickly in response to a given electric field than a material with a lower carrier mobility. Accordingly, high carrier mobilities may be associated with improved performance. Although shown and described above as single semiconducting oxide layers, in accordance with embodiments described herein, a layer of a semiconducting oxide, such as a layer of IGZO, is between a high-k gate dielectric material and a higher mobility semiconducting oxide channel material. Although IGZO has a relatively low mobility (approximately 10 cm²/V-s), the sub threshold swing of IGZO may be close to the conventional theoretical lower limit. In some embodiments, a thin layer of IGZO may directly border a channel material of choice, and may be sandwiched between the channel material and the high-k dielectric. The use of IGZO at the interface between the gate stack and the channel may achieve one or more of a number of advantages. For example, an IGZO interface may have a relatively small number of interface traps, defects at which carriers are trapped and released that impede performance. A TFT that includes an IGZO layer as a second semiconducting oxide material may exhibit desirably low gate leakage. When IGZO is used as an interface to a non-IGZO semiconducting oxide channel material (e.g., a thin film oxide semiconductor material having a higher mobility than IGZO), the benefits of the higher mobility channel material may be realized simultaneously with the good gate oxide interface properties provided by the IGZO. In accordance with one or more embodiments described herein, a gate-channel arrangement based on a dual semiconducting oxide layer channel enables the use of a wider array of thin film transistor channel materials, while achieving desirable gate control, than realizable using conventional approaches.

In an embodiment, the addition of a second thin film semiconductor around a first TFT material can provide one or more of mobility enhancement, improved short channel effects (SCEs) particularly if all conduction occurs in the second material. The second TFT material may be selected for strong oxygen bond capability in order to stabilize the TFT when exposed to downstream processing. In accordance with one embodiment, a higher mobility semiconducting oxide material is effectively wrapped in a lower mobility material semiconducting oxide that is more oxygen stable. The resulting structure may limit the negative effects of downstream high temperature processing operations or aggressive operations on the inner TFT material by having the highly stable outer material. An increased set of materials that can be chosen to maximize stability and mobility simultaneously may be achieved using such a dual material architecture.

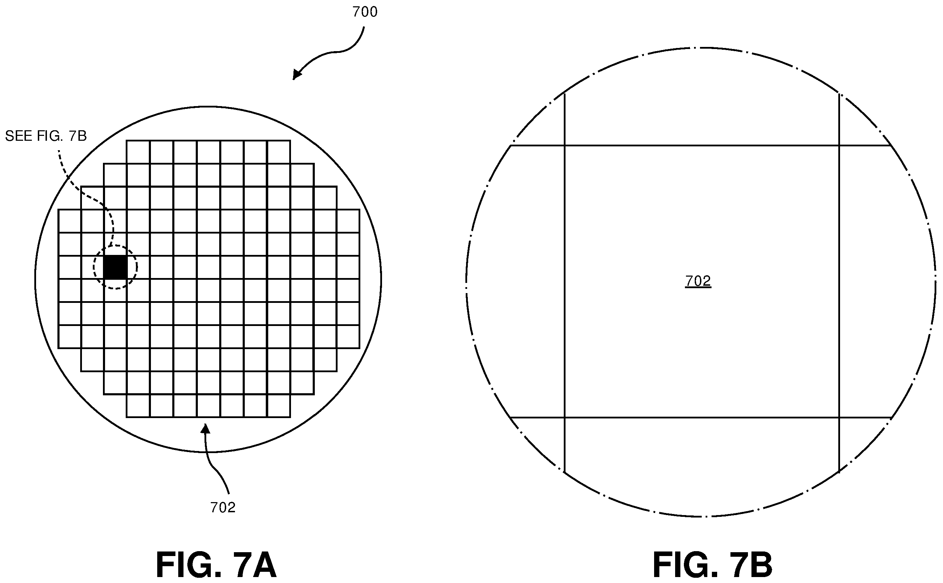

In another aspect, the integrated circuit structures described herein may be included in an electronic device. As a first example of an apparatus that may include one or more of the TFTs disclosed herein, Figures 7A and 7B are top views of a wafer and dies that include one or more thin film transistors having recessed contact metallization, in accordance with any of the embodiments disclosed herein.

Referring to Figures 7A and 7B, a wafer 700 may be composed of semiconductor material and may include one or more dies 702 having integrated circuit (IC) structures formed on a surface of the wafer 700. Each of the dies 702 may be a repeating unit of a semiconductor product that includes any suitable IC (e.g., ICs including one or more TFT structures. After the fabrication of the semiconductor product is complete, the wafer 700 may undergo a singulation process in which each of the dies 702 is separated from one another to provide discrete "chips" of the semiconductor product. In particular, devices that include TFT as disclosed herein may take the form of the wafer 700 (e.g., not singulated) or the form of the die 702 (e.g., singulated). The die 702 may include one or more transistors and/or supporting circuitry to route electrical signals to the transistors, as well as any other IC components. In some embodiments, the wafer 700 or the die 702 may include a memory device (e.g., a static random access memory (SRAM) device), a logic device (e.g., an AND, OR, NAND, or NOR gate), or any other suitable circuit element. Multiple ones of these devices may be combined on a single die 702. For example, a memory array formed by multiple memory devices may be formed on a same die 702 as a processing device or other logic that is configured to store information in the memory devices or execute instructions stored in the memory array.

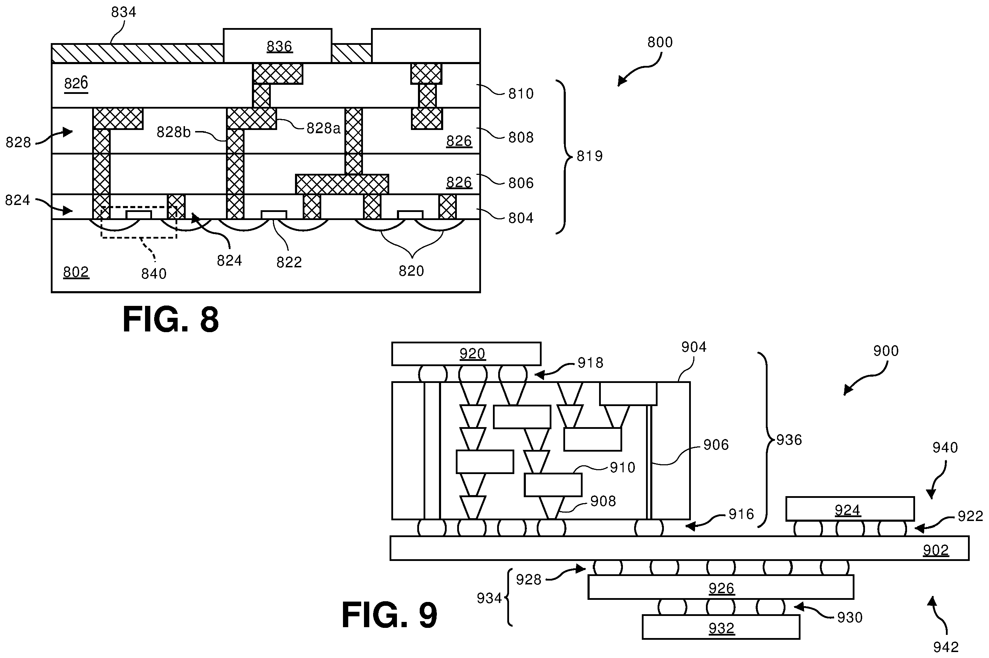

Figure 8 is a cross-sectional side view of an integrated circuit (IC) device that may include one or more thin film transistors having recessed contact metallization, in accordance with one or more of the embodiments disclosed herein.

Referring to Figure 8, an IC device 800 is formed on a substrate 802 (e.g., the wafer 700 of Figure 7A) and may be included in a die (e.g., the die 702 of Figure 7B), which may be singulated or included in a wafer. Although a few examples of materials from which the substrate 802 may be formed are described above, any material that may serve as a foundation for an IC device 800 may be used.

The IC device 800 may include one or more device layers, such as device layer 804, disposed on the substrate 802. The device layer 804 may include features of one or more transistors 840 (e.g., TFTs described above) formed on the substrate 802. The device layer 804 may include, for example, one or more source and/or drain (S/D) regions 820, a gate 822 to control current flow in the transistors 840 between the S/D regions 820, and one or more S/D contacts 824 to route electrical signals to/from the S/D regions 820. The transistors 840 may include additional features not depicted for the sake of clarity, such as device isolation regions, gate contacts, and the like. The transistors 840 are not limited to the type and configuration depicted in Figure 8 and may include a wide variety of other types and configurations such as, for example, planar transistors, non-planar transistors, or a combination of both. Non-planar transistors may include Fin-based transistors, such as double-gate transistors or tri-gate transistors, and wrap-around or all-around gate transistors, such as nanoribbon and nanowire transistors. In particular, one or more of the transistors 840 take the form of the TFTs described above. Thin-film transistors such as described above may be particularly advantageous when used in the metal layers of a microprocessor device for analog circuitry, logic circuitry, or memory circuitry, and may be formed along with existing complementary metal oxide semiconductor (CMOS) processes.

Electrical signals, such as power and/or input/output (I/O) signals, may be routed to and/or from the transistors 840 of the device layer 804 through one or more interconnect layers disposed on the device layer 804 (illustrated in Figure 8 as interconnect layers 806-810). For example, electrically conductive features of the device layer 804 (e.g., the gate 822 and the S/D contacts 824) may be electrically coupled with the interconnect structures 828 of the interconnect layers 806-810. The one or more interconnect layers 806-810 may form an interlayer dielectric (ILD) stack 819 of the IC device 800.

The interconnect structures 828 may be arranged within the interconnect layers 806-810 to route electrical signals according to a wide variety of designs (in particular, the arrangement is not limited to the particular configuration of interconnect structures 828 depicted in Figure 8). Although a particular number of interconnect layers 806-810 is depicted in Figure 8, embodiments of the present disclosure include IC devices having more or fewer interconnect layers than depicted.

In some embodiments, the interconnect structures 828 may include trench structures 828a (sometimes referred to as "lines") and/or via structures 828b filled with an electrically conductive material such as a metal. The trench structures 828a may be arranged to route electrical signals in a direction of a plane that is substantially parallel with a surface of the substrate 802 upon which the device layer 804 is formed. For example, the trench structures 828a may route electrical signals in a direction in and out of the page from the perspective of Figure 8. The via structures 828b may be arranged to route electrical signals in a direction of a plane that is substantially perpendicular to the surface of the substrate 802 upon which the device layer 804 is formed. In some embodiments, the via structures 828b may electrically couple trench structures 828a of different interconnect layers 806-810 together.

The interconnect layers 806-810 may include a dielectric material 826 disposed between the interconnect structures 828, as shown in Figure 8. In some embodiments, the dielectric material 826 disposed between the interconnect structures 828 in different ones of the interconnect layers 806-810 may have different compositions; in other embodiments, the composition of the dielectric material 826 between different interconnect layers 806-810 may be the same. In either case, such dielectric materials may be referred to as inter-layer dielectric (ILD) materials.

A first interconnect layer 806 (referred to as Metal 1 or "M1") may be formed directly on the device layer 804. In some embodiments, the first interconnect layer 806 may include trench structures 828a and/or via structures 828b, as shown. The trench structures 828a of the first interconnect layer 806 may be coupled with contacts (e.g., the S/D contacts 824) of the device layer 804.

A second interconnect layer 808 (referred to as Metal 2 or "M2") may be formed directly on the first interconnect layer 806. In some embodiments, the second interconnect layer 808 may include via structures 828b to couple the trench structures 828a of the second interconnect layer 808 with the trench structures 828a of the first interconnect layer 806. Although the trench structures 828a and the via structures 828b are structurally delineated with a line within each interconnect layer (e.g., within the second interconnect layer 808) for the sake of clarity, the trench structures 828a and the via structures 828b may be structurally and/or materially contiguous (e.g., simultaneously filled during a dual-damascene process) in some embodiments.

A third interconnect layer 810 (referred to as Metal 3 or "M3") (and additional interconnect layers, as desired) may be formed in succession on the second interconnect layer 808 according to similar techniques and configurations described in connection with the second interconnect layer 808 or the first interconnect layer 806.

The IC device 800 may include a solder resist material 834 (e.g., polyimide or similar material) and one or more bond pads 836 formed on the interconnect layers 806-810. The bond pads 836 may be electrically coupled with the interconnect structures 828 and configured to route the electrical signals of the transistor(s) 840 to other external devices. For example, solder bonds may be formed on the one or more bond pads 836 to mechanically and/or electrically couple a chip including the IC device 800 with another component (e.g., a circuit board). The IC device 800 may have other alternative configurations to route the electrical signals from the interconnect layers 806-810 than depicted in other embodiments. For example, the bond pads 836 may be replaced by or may further include other analogous features (e.g., posts) that route the electrical signals to external components.

Figure 9 is a cross-sectional side view of an integrated circuit (IC) device assembly that may include one or more thin film transistors having recessed contact metallization, in accordance with one or more of the embodiments disclosed herein.

Referring to Figure 9, an IC device assembly 900 includes components having one or more integrated circuit structures described herein. The IC device assembly 900 includes a number of components disposed on a circuit board 902 (which may be, e.g., a motherboard). The IC device assembly 900 includes components disposed on a first face 940 of the circuit board 902 and an opposing second face 942 of the circuit board 902. Generally, components may be disposed on one or both faces 940 and 942. In particular, any suitable ones of the components of the IC device assembly 900 may include a number of the TFT structures, such as those disclosed herein.

In some embodiments, the circuit board 902 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 902. In other embodiments, the circuit board 902 may be a non-PCB substrate.

The IC device assembly 900 illustrated in Figure 9 includes a package-on-interposer structure 936 coupled to the first face 940 of the circuit board 902 by coupling components 916. The coupling components 916 may electrically and mechanically couple the package-on-interposer structure 936 to the circuit board 902, and may include solder balls (as shown in Figure 9), male and female portions of a socket, an adhesive, an underfill material, and/or any other suitable electrical and/or mechanical coupling structure.

The package-on-interposer structure 936 may include an IC package 920 coupled to an interposer 904 by coupling components 918. The coupling components 918 may take any suitable form for the application, such as the forms discussed above with reference to the coupling components 916. Although a single IC package 920 is shown in Figure 9, multiple IC packages may be coupled to the interposer 904. It is to be appreciated that additional interposers may be coupled to the interposer 904. The interposer 904 may provide an intervening substrate used to bridge the circuit board 902 and the IC package 920. The IC package 920 may be or include, for example, a die (the die 702 of Figure 7B), an IC device (e.g., the IC device 800 of Figure 8), or any other suitable component. Generally, the interposer 904 may spread a connection to a wider pitch or reroute a connection to a different connection. For example, the interposer 904 may couple the IC package 920 (e.g., a die) to a ball grid array (BGA) of the coupling components 916 for coupling to the circuit board 902. In the embodiment illustrated in Figure 9, the IC package 920 and the circuit board 902 are attached to opposing sides of the interposer 904. In other embodiments, the IC package 920 and the circuit board 902 may be attached to a same side of the interposer 904. In some embodiments, three or more components may be interconnected by way of the interposer 904.

The interposer 904 may be formed of an epoxy resin, a fiberglass-reinforced epoxy resin, a ceramic material, or a polymer material such as polyimide. In some implementations, the interposer 904 may be formed of alternate rigid or flexible materials that may include the same materials described above for use in a semiconductor substrate, such as silicon, germanium, and other group III-V and group IV materials. The interposer 904 may include metal interconnects 910 and vias 908, including but not limited to through-silicon vias (TSVs) 906. The interposer 904 may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 904. The package-on-interposer structure 936 may take the form of any of the package-on-interposer structures known in the art.

The IC device assembly 900 may include an IC package 924 coupled to the first face 940 of the circuit board 902 by coupling components 922. The coupling components 922 may take the form of any of the embodiments discussed above with reference to the coupling components 916, and the IC package 924 may take the form of any of the embodiments discussed above with reference to the IC package 920.

The IC device assembly 900 illustrated in Figure 9 includes a package-on-package structure 934 coupled to the second face 942 of the circuit board 902 by coupling components 928. The package-on-package structure 934 may include an IC package 926 and an IC package 932 coupled together by coupling components 930 such that the IC package 926 is disposed between the circuit board 902 and the IC package 932. The coupling components 928 and 930 may take the form of any of the embodiments of the coupling components 916 discussed above, and the IC packages 926 and 932 may take the form of any of the embodiments of the IC package 920 discussed above. The package-on-package structure 934 may be configured in accordance with any of the package-on-package structures known in the art.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

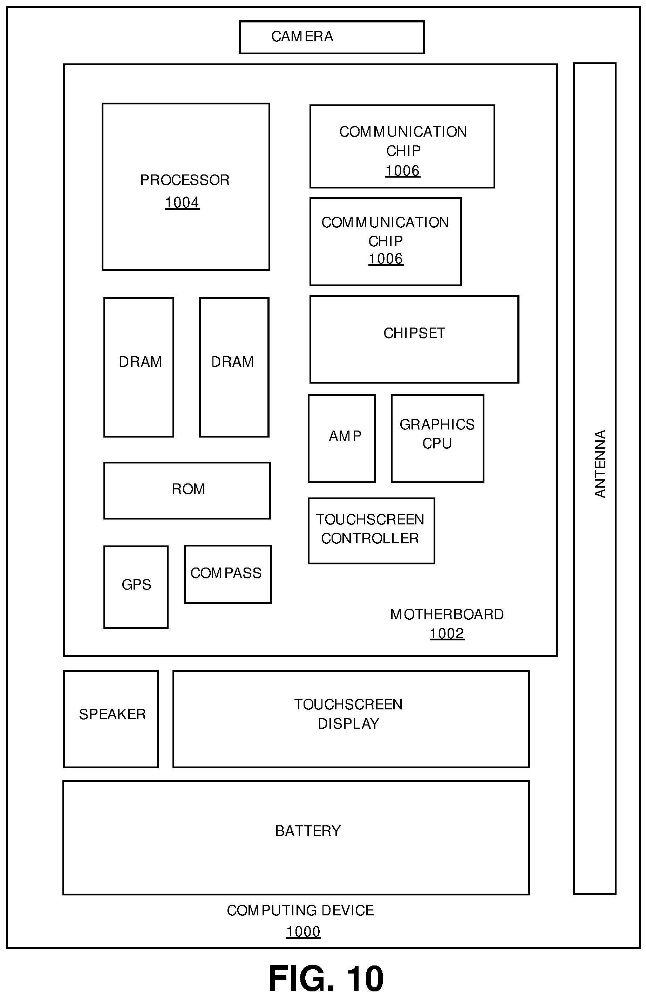

Figure 10 illustrates a computing device 1000 in accordance with one implementation of the disclosure. The computing device 1000 houses a board 1002. The board 1002 may include a number of components, including but not limited to a processor 1004 and at least one communication chip 1006. The processor 1004 is physically and electrically coupled to the board 1002. In some implementations the at least one communication chip 1006 is also physically and electrically coupled to the board 1002. In further implementations, the communication chip 1006 is part of the processor 1004.

Depending on its applications, computing device 1000 may include other components that may or may not be physically and electrically coupled to the board 1002. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1006 enables wireless communications for the transfer of data to and from the computing device 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing device 1000 includes an integrated circuit die packaged within the processor 1004. In some implementations of the disclosure, the integrated circuit die of the processor includes one or more thin film transistors having recessed contact metallization, in accordance with implementations of embodiments of the disclosure. The term "processor" may refer to any device or portion of a device that processes electronic data from registers and/or memory to transform that electronic data into other electronic data that may be stored in registers and/or memory.

The communication chip 1006 also includes an integrated circuit die packaged within the communication chip 1006. In accordance with another implementation of embodiments of the disclosure, the integrated circuit die of the communication chip includes one or more thin film transistors having recessed contact metallization, in accordance with implementations of embodiments of the disclosure.

In further implementations, another component housed within the computing device 1000 may contain an integrated circuit die that includes one or more thin film transistors having recessed contact metallization, in accordance with implementations of embodiments of the disclosure.

In various implementations, the computing device 1000 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 1000 may be any other electronic device that processes data.

Thus, embodiments described herein include thin film transistors having recessed contact metallization.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description. The terms used in the following claims should not be construed to limit the disclosure to the specific implementations disclosed in the specification and the claims.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of the present disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of the present application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment. The following examples pertain to further embodiments. The various features of the different embodiments may be variously combined with some features included and others excluded to suit a variety of different applications.

Example embodiment 1: An integrated circuit structure includes a gate electrode. A gate dielectric layer is on the gate electrode. A planar channel material layer is on the gate dielectric layer. A dielectric layer is over the planar channel material layer. Source or drain contacts are on the planar channel material layer. Each of the source or drain contacts includes a semiconductor material layer, a conductive liner within the semiconductor material layer, and a conductive fill within the conductive liner. One, two or all three of the semiconductor material layer, the conductive liner, or the conductive fill has an uppermost surface below an uppermost surface of the dielectric layer.

Example embodiment 2: The integrated circuit structure of example embodiment 1, wherein the uppermost surface of the semiconductor material layer is below the uppermost surface of the dielectric layer, the uppermost surface of the conductive liner is at a same level as the uppermost surface of the dielectric layer, and the uppermost surface of the conductive fill is at a same level as the uppermost surface of the dielectric layer.

Example embodiment 3: The integrated circuit structure of example embodiment 1, wherein the uppermost surface of the semiconductor material layer is below the uppermost surface of the dielectric layer, the uppermost surface of the conductive liner is below the uppermost surface of the dielectric layer, and the uppermost surface of the conductive fill is at a same level as the uppermost surface of the dielectric layer.

Example embodiment 4: The integrated circuit structure of example embodiment 1, wherein the uppermost surface of the semiconductor material layer is at a same level as the uppermost surface of the dielectric layer, the uppermost surface of the conductive liner is below the uppermost surface of the dielectric layer, and the uppermost surface of the conductive fill is below the uppermost surface of the dielectric layer.

Example embodiment 5: The integrated circuit structure of example embodiment 1, wherein the uppermost surface of the semiconductor material layer is below the uppermost surface of the dielectric layer, the uppermost surface of the conductive liner is below the uppermost surface of the dielectric layer, and the uppermost surface of the conductive fill is below the uppermost surface of the dielectric layer.

Example embodiment 6: An integrated circuit structure includes a gate electrode. A gate dielectric layer is on the gate electrode. A non-planar channel material layer is on the gate dielectric layer. A dielectric layer is over the non-planar channel material layer. Source or drain contacts are on the non-planar channel material layer. Each of the source or drain contacts includes a semiconductor material layer, a conductive liner within the semiconductor material layer, and a conductive fill within the conductive liner. One, two or all three of the semiconductor material layer, the conductive liner, or the conductive fill has an uppermost surface below an uppermost surface of the dielectric layer.

Example embodiment 7: The integrated circuit structure of example embodiment 6, wherein the uppermost surface of the semiconductor material layer is below the uppermost surface of the dielectric layer, the uppermost surface of the conductive liner is at a same level as the uppermost surface of the dielectric layer, and the uppermost surface of the conductive fill is at a same level as the uppermost surface of the dielectric layer.

Example embodiment 8: The integrated circuit structure of example embodiment 6, wherein the uppermost surface of the semiconductor material layer is below the uppermost surface of the dielectric layer, the uppermost surface of the conductive liner is below the uppermost surface of the dielectric layer, and the uppermost surface of the conductive fill is at a same level as the uppermost surface of the dielectric layer.

Example embodiment 9: The integrated circuit structure of example embodiment 6, wherein the uppermost surface of the semiconductor material layer is at a same level as the uppermost surface of the dielectric layer, the uppermost surface of the conductive liner is below the uppermost surface of the dielectric layer, and the uppermost surface of the conductive fill is below the uppermost surface of the dielectric layer.

Example embodiment 10: The integrated circuit structure of example embodiment 6, wherein the uppermost surface of the semiconductor material layer is below the uppermost surface of the dielectric layer, the uppermost surface of the conductive liner is below the uppermost surface of the dielectric layer, and the uppermost surface of the conductive fill is below the uppermost surface of the dielectric layer.

Example embodiment 11: A computing device includes a board, and a component coupled to the board. The component includes an integrated circuit structure including a gate electrode. A gate dielectric layer is on the gate electrode. A planar or a non-planar channel material layer is on the gate dielectric layer. A dielectric layer is over the planar or the non-planar channel material layer. Source or drain contacts are on the planar or the non-planar channel material layer. Each of the source or drain contacts includes a semiconductor material layer, a conductive liner within the semiconductor material layer, and a conductive fill within the conductive liner. One, two or all three of the semiconductor material layer, the conductive liner, or the conductive fill has an uppermost surface below an uppermost surface of the dielectric layer.

Example embodiment 12: The computing device of example embodiment 11, including the planar channel material layer.

Example embodiment 13: The computing device of example embodiment 11, including the non-planar channel material layer.

Example embodiment 14: The computing device of example embodiment 11, 12 or 13, further including a memory coupled to the board.

Example embodiment 15: The computing device of example embodiment 11, 12, 13 or 14, further including a communication chip coupled to the board.

Example embodiment 16: The computing device of example embodiment 11, 12, 13, 14 or 15, further including a battery coupled to the board.

Example embodiment 17: The computing device of example embodiment 11, 12, 13, 14, 15 or 16, further including a camera coupled to the board.

Example embodiment 18: The computing device of example embodiment 11, 12, 13, 14, 15, 16 or 17, further including a display coupled to the board.

Example embodiment 19: The computing device of example embodiment 11, 12, 13, 14, 15, 16, 17 or 18, wherein the component is a packaged integrated circuit die.

Example embodiment 20: The computing device of example embodiment 11, 12, 13, 14, 15, 16, 17, 18 or 19, wherein the component is selected from the group consisting of a processor, a communications chip, and a digital signal processor.

## Claims

1. An integrated circuit structure, comprising:
a gate electrode;
a gate dielectric layer on the gate electrode;
a planar channel material layer on the gate dielectric layer;
a dielectric layer over the planar channel material layer; and
source or drain contacts on the planar channel material layer, each of the source or drain contacts including a semiconductor material layer, a conductive liner within the semiconductor material layer, and a conductive fill within the conductive liner, wherein one, two or all three of the semiconductor material layer, the conductive liner, or the conductive fill has an uppermost surface below an uppermost surface of the dielectric layer.

2. The integrated circuit structure of claim 1, wherein the uppermost surface of the semiconductor material layer is below the uppermost surface of the dielectric layer, the uppermost surface of the conductive liner is at a same level as the uppermost surface of the dielectric layer, and the uppermost surface of the conductive fill is at a same level as the uppermost surface of the dielectric layer.

3. The integrated circuit structure of claim 1, wherein the uppermost surface of the semiconductor material layer is below the uppermost surface of the dielectric layer, the uppermost surface of the conductive liner is below the uppermost surface of the dielectric layer, and the uppermost surface of the conductive fill is at a same level as the uppermost surface of the dielectric layer.

4. The integrated circuit structure of claim 1, wherein the uppermost surface of the semiconductor material layer is at a same level as the uppermost surface of the dielectric layer, the uppermost surface of the conductive liner is below the uppermost surface of the dielectric layer, and the uppermost surface of the conductive fill is below the uppermost surface of the dielectric layer.

5. The integrated circuit structure of claim 1, wherein the uppermost surface of the semiconductor material layer is below the uppermost surface of the dielectric layer, the uppermost surface of the conductive liner is below the uppermost surface of the dielectric layer, and the uppermost surface of the conductive fill is below the uppermost surface of the dielectric layer.

6. A method of fabricating an integrated circuit structure, the method comprising:
forming a gate electrode;
forming a gate dielectric layer on the gate electrode;
forming a planar channel material layer on the gate dielectric layer;
forming a dielectric layer over the planar channel material layer; and
forming source or drain contacts on the planar channel material layer, each of the source or drain contacts including a semiconductor material layer, a conductive liner within the semiconductor material layer, and a conductive fill within the conductive liner, wherein one, two or all three of the semiconductor material layer, the conductive liner, or the conductive fill has an uppermost surface below an uppermost surface of the dielectric layer.

7. The method of claim 6, wherein the uppermost surface of the semiconductor material layer is below the uppermost surface of the dielectric layer, the uppermost surface of the conductive liner is at a same level as the uppermost surface of the dielectric layer, and the uppermost surface of the conductive fill is at a same level as the uppermost surface of the dielectric layer.

8. The method of claim 6, wherein the uppermost surface of the semiconductor material layer is below the uppermost surface of the dielectric layer, the uppermost surface of the conductive liner is below the uppermost surface of the dielectric layer, and the uppermost surface of the conductive fill is at a same level as the uppermost surface of the dielectric layer.

9. The method of claim 6, wherein the uppermost surface of the semiconductor material layer is at a same level as the uppermost surface of the dielectric layer, the uppermost surface of the conductive liner is below the uppermost surface of the dielectric layer, and the uppermost surface of the conductive fill is below the uppermost surface of the dielectric layer.

10. The method of claim 6, wherein the uppermost surface of the semiconductor material layer is below the uppermost surface of the dielectric layer, the uppermost surface of the conductive liner is below the uppermost surface of the dielectric layer, and the uppermost surface of the conductive fill is below the uppermost surface of the dielectric layer.
